# EUROPEAN PATENT APPLICATION

(11) **EP 2 765 175 A2**
(43) Date of publication of application: **13.08.2014**
(21) Application number: 14152868.7
(22) Date of filing: 28.01.2014
(51) Int. Cl.: C09K 11/08, C09K 11/77, H01L 33/50

(54) **Phosphor compositions for highly reliable white light-emitting diode devices**

(30) Priority: 07.02.2013 US 201361761924 P
(71) Applicant: Everlight Electronics Co., Ltd, New Taipei City 23860 (TW)
(72) Inventor: Yang, Yao-Yu, 23860 New Taipei City (TW); Lu, Kuang-Mao, 23860 New Taipei City (TW)
(74) Representative: Becker Kurig Straus

(57) **Abstract**

Phosphor compositions for highly reliable white light-emitting diode (LED) devices are disclosed. The phosphor compositions include a first oxynitride-based phosphor that emits green light and a second nitride-based phosphor that emits red light. When the weight ratio of the first oxynitride-based phosphor to the second nitride-based phosphor is from about 8:2 to 9:1, the emission spectra of the phosphor compositions are very similar to that of a yellow YAG phosphor with a peak at 550 nm. The phosphor compositions have emissions with CIE color coordinates satisfying an equation expressed as: y = 0.0805x³ - 154.06x² + 97017x - 2E+07.

## Description

### CROSS REFERENCE TO RELATED PATENT APPLICATION

This application is the non-provisional of, and claims the priority benefit of, U.S. Patent Application No. 61/761,924, filed on 07 February 2013, which is incorporated by reference in its entirety.

### TECHNICAL FIELD

The present disclosure relates to phosphor compositions and, more specifically, to phosphor compositions used in white light-emitting diode (LED) devices.

### BACKGROUND

With the recent trend of rising demand for slimness and high performance in image display devices, liquid crystal displays (LCD) have been widely used in a wide array of consumer products, including televisions, computer monitors and smart-phone displays. A LCD panel cannot emit light by itself, thus requiring a separate light source unit, e.g., a backlight unit. Choosing a backlight unit for LCDs is a major consideration since the backlight unit significantly affects the brightness, the contrast, and many other aspects of the viewing experience. White LEDs have recently gained popularity as the backlight units due to their low power consumption, high reliability, and long operating lifetime.

A white LED is typically composed of a blue LED and a yellow phosphor. A part of the blue light emitted by the blue LED excites the yellow phosphor causing it to emit yellow light; and the yellow color mixes with another part of the blue light from the blue LED to create the white light. In addition, the LED can use a mixture of green and red phosphors which convert the blue light of the LED at least partially into green and red luminescent radiation. Owing to the resultant additive color mixing of the colors blue, red and green, white light can therefore be produced. Generally, the phosphor determines luminescence efficiency, color rendering, color temperature, and lifespan of the white LEDs.

To lower manufacturing cost, the number of white LEDs per backlight unit needs to be reduced. In turn, the white LEDs have to be driven at a much higher voltage so that the brightness of the backlight unit can remain the same. This would require utilizing phosphors with high thermal stability in the white LEDs.

In the field, the most commonly used yellow light-emitting phosphor is Ce doped yttrium aluminum garnet (YAG:Ce) which shows unsurpassed efficiency. Silicate-based phosphors have been developed as an alternative to YAG. However, silicate-based phosphors have poor stability in high temperature and high humidity environments. Therefore, while these phosphors are efficient at room temperature, they suffer relatively strong quenching at elevated temperature. Accordingly, there remains a need to develop a new phosphor composition that has an emission and thermal stability similar to YAG phosphor, as a viable alternative to YAG phosphor.

### SUMMARY

The present disclosure provides a phosphor composition as well as a highly reliable white LED device using such phosphor composition to address the aforementioned problems.

In one aspect, a phosphor composition is provided. The phosphor composition may comprise a first oxynitride-based phosphor that emits green light; and a second nitride-based phosphor that emits red light. The phosphor composition may have an emission with CIE color coordinates satisfying an equation expressed as: y = 0.0805x3 - 154.06x2 + 97017x - 2E+07.

In one embodiment, the first oxynitride-based phosphor may be represented by a general formula of M(II)ₐSi_{b}O_{c}N_{d}Cₑ:A. In M(II)ₐSi_{b}O_{c}N_{d}Cₑ:A, M(II) may comprises Be, Mg, Ca, Sr, Ba, Cu, Co, Ni, Pd, Zn, Cd, or a combination thereof. A may comprises a luminescence activator selected from the group consisting of Ce, Pr, Nd, Sm, Eu, Gd, Tb, Dy, Ho, Er, Tm, Yb, Lu, Mn, Bi, and Sb. Additionally, the following conditions may exist: 6<a<8, 8<b<14, 13<c<17, 5<d<9, and 0<e<2.

In one embodiment, the second nitride-based phosphor may be represented by a formula of CaAlSiN₃:Eu.

In one embodiment, a weight ratio of the first oxynitride-based phosphor to the second nitride-based phosphor may be from about 8:2 to about 9:1.

In one embodiment, the weight ratio of the first oxynitride-based phosphor to the second nitride-based phosphor may be about 8.04:1.95.

In one embodiment, the CIE color coordinates of the phosphor composition may fall within a region defined by points having coordinates of (0.30, 0.25), (0.30, 0.43), (0.39, 0.25), and (0.39, 0.43).

In one embodiment, the CIE color coordinates of the emission of the phosphor composition may be at (0.365, 0.372).

In another aspect, a phosphor composition is provided. The phosphor composition may comprise a first oxynitride-based phosphor, represented by a general formula of M(II)ₐSi_{b}O_{c}N_{d}Cₑ:A; and a second nitride-based phosphor, represented by a formula of CaAlSiN₃:Eu. In M(II)ₐSi_{b}O_{c}N_{d}Cₑ:A, M(II) may comprise at least one divalent cation selected from the group consisting of Be, Mg, Ca, Sr, Ba, Cu, Co, Ni, Pd, Zn, and Cd. A may comprise a luminescence activator selected from the group consisting of Ce, Pr, Nd, Sm, Eu, Gd, Tb, Dy, Ho, Er, Tm, Yb, Lu, Mn, Bi, and Sb. Additionally, the following conditions may exist: 6<a<8, 8<b<14, 13<c<17, 5<d<9, and 0<e<2. A weight ratio of the first oxynitride-based phosphor to the second nitride-based phosphor may be from about 8:2 to about 9:1.

In one embodiment, the weight ratio of the first oxynitride-based phosphor to the second nitride-based phosphor may be about 8.04:1.95.

In one embodiment, the phosphor composition may have an emission with CIE color coordinates satisfying an equation expressed as: y = 0.0805x³-154.06x² + 97017x - 2E+07.

In one embodiment, the CIE color coordinates of the emission of the phosphor composition may fall within a region defined by points having coordinates of (0.30, 0.25), (0.30, 0.43), (0.39, 0.25), and (0.39, 0.43).

In another aspect, a phosphor composition is provided. The phosphor composition may comprise a first oxynitride-based phosphor, represented by a general formula of M(II)ₐSi_{b}O_{c}N_{d}Cₑ:A; and a second nitride-based phosphor, represented by a formula of CaAlSiN₃:Eu. In M(II)ₐSi_{b}O_{c}N_{d}Cₑ:A, M(II) may comprise at least one divalent cation selected from the group consisting of Be, Mg, Ca, Sr, Ba, Cu, Co, Ni, Pd, Zn, and Cd. A may comprise a luminescence activator selected from the group consisting of Ce, Pr, Nd, Sm, Eu, Gd, Tb, Dy, Ho, Er, Tm, Yb, Lu, Mn, Bi, and Sb. Additionally, the following conditions may exist: 6<a<8, 8<b<14, 13<c<17, 5<d<9, and 0<e<2. The phosphor composition may have an emission with CIE color coordinates in a range of 0.356 ≤ x ≤ 0.365 and 0.372 ≤ y ≤ 0.380.

In one embodiment, the weight ratio of the first oxynitride-based phosphor to the second nitride-based phosphor may be about 8.04:1.95.

In one embodiment, the phosphor composition may have an emission with CIE color coordinates satisfying an equation expressed as: y = 0.0805x³-154.06x² + 97017x - 2E+07.

In yet another aspect, a light-emitting diode (LED) device is provided. The LED device may comprise a blue LED having a peak emission wavelength in a range of 450 nm - 460 nm, and a phosphor composition disposed on or over the LED. The phosphor composition may comprise a first oxynitride-based phosphor having a peak emission wavelength in a range of 550 nm - 560 nm; and a second nitride-based phosphor having a peak emission wavelength in a range of 570 nm - 600 nm. The phosphor composition may have an emission with CIE color coordinates satisfying an equation expressed as: y = 0.0805x³ - 154.06x² + 97017x - 2E+07.

In one embodiment, the first oxynitride-based phosphor may be represented by a general formula of M(II)ₐSi_{b}O_{c}N_{d}Cₑ:A. In M(II)ₐSi_{b}O_{c}N_{d}Cₑ:A, M(II) may comprise Be, Mg, Ca, Sr, Ba, Cu, Co, Ni, Pd, Zn, Cd, or a combination thereof, and A may comprise a luminescence activator selected from the group consisting of Ce, Pr, Nd, Sm, Eu, Gd, Tb, Dy, Ho, Er, Tm, Yb, Lu, Mn, Bi, and Sb. Additionally, the following conditions may exist: 6<a<8, 8<b<14, 13<c<17, 5<d<9, and 0<e<2.

In one embodiment, the second nitride-based phosphor may be represented by a formula of CaAlSiN₃:Eu.

In one embodiment, a weight ratio of the first oxynitride-based phosphor to the second nitride-based phosphor may be from about 8:2 to about 9:1.

In one embodiment, the weight ratio of the first oxynitride-based phosphor to the second nitride-based phosphor may be about 8.04:1.95.

In one embodiment, the CIE color coordinates of the emission of the phosphor composition may be fall with a region defined by points having coordinates of (0.30, 0.25), (0.30, 0.43), (0.39, 0.25), and (0.39, 0.43).

In one embodiment, the CIE color coordinates of the emission of the phosphor composition are in a range of 0.356 ≤ x ≤ 0.365 and 0.372 ≤ y ≤ 0.380.

In one embodiment, the CIE color coordinates of emission of the LED device are in a range of 0.28 ≤ x ≤ 0.39 and 0.25 ≤ y ≤ 0.35.

In one embodiment, the LED device may additionally comprise a diffuser.

In one embodiment, the diffuser may comprise ZnO₂, SiO₂, TiO₂, Al₂O₃, or a combination thereof.

Detailed description of various embodiments are provided below, with reference to the attached figures, to promote better understanding of the characteristics and benefits of the various embodiments of the present disclosure.

### BRIEF DESCRIPTION OF THE DRAWINGS

Figure 1 is a cross-sectional view of a white light-emitting diode device in accordance with one embodiment of the present disclosure.
Figure 2 shows a comparison of optical emission between a phosphor composition in accordance with one embodiment of the present disclosure and a yellow YAG phosphor.

### DETAILED DESCRIPTION OF DISCLOSED EMBODIMENTS

The present disclosure provides phosphor compositions with emission and thermal stability similar to the yttrium aluminum garnet (YAG) phosphor for high reliability white LED devices.

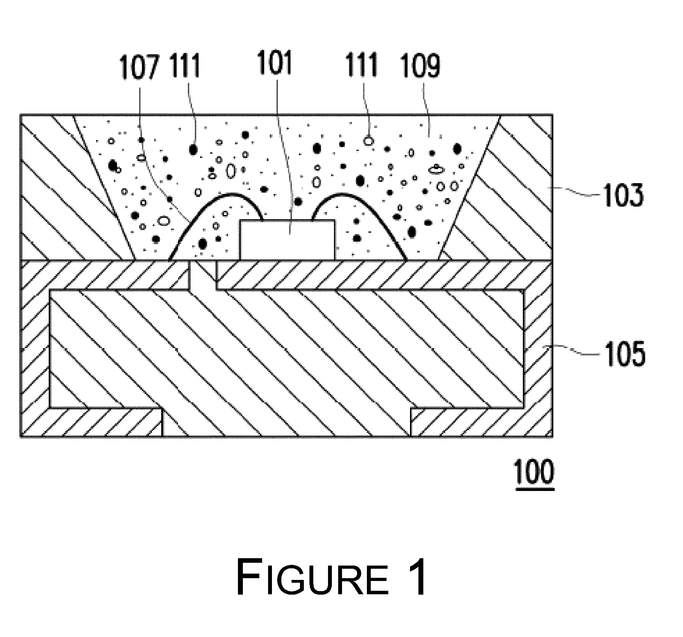

Figure 1 illustrates a cross-sectional view of a white light-emitting diode (LED) device 100 in accordance with one embodiment of the preset disclosure. Referring to Figure 1, the white LED device 100 comprises a blue LED 101, a reflection shell 103 and an electrically conductive leadframe 105. The blue LED 101 is disposed inside the reflection shell 103 and is electrically connected to the lead frame 105 via electrically-conductive wires 107. An encapsulant layer 109 is filled inside the reflection shell 103 and covers the blue LED 101. A phosphor composition 111 is mixed in the encapsulant layer 109 and disposed on and over the blue LED 101. The blue LED 101 emits light having a wavelength ranging from 410 nm to 480 nm with a peak wavelength from about 450 nm to 460 nm. The white LED device 100 has an emission with CIE color coordinates in a range of 0.28 ≤ x ≤ 0.39 and 0.25 ≤ y ≤ 0.35.

In the above-described phosphor composition 111 of the white LED device 100, in order to produce emission similar to that of the YAG phosphor, a first oxynitride-based green-emitting phosphor and a second nitride-based red-emitting phosphor are mixed in an appropriate proportion. The first oxynitride-based phosphor emits in the green region with an emission peak ranging from about 550 nm to 560 nm when excited by blue or ultraviolet light. The second nitride-based phosphor emits in the red region with an emission peak ranging from about 570 nm to 600 nm when excited by blue or ultraviolet light.

In the above-described phosphor composition 111, the first oxynitride-based phosphor is represented by a general formula of M(II)ₐSi_{b}O_{c}N_{d}Cₑ:A, wherein 6<a<8, 8<b<14, 13<c<17, 5<d<9, and 0<e<2; preferably 6.5<a<7.5, 8.5<b<12.5, 14<c<16, 6<d<7.5, and 0<e<1. M(II) comprises at least one divalent cation, and may be selected from the group consisting of Be, Mg, Ca, Sr, Ba, Cu, Co, Ni, Pd, Zn, and Cd. A comprises a luminescence activator doped in the host crystal of the first oxynitride-based phosphor at a concentration from about 0.001 mol % to about 20 mol %, preferably from about 0.1 mol % to about 10 mol %, relative to M(II). In one embodiment, A may be selected from the group consisting of Ce, Pr, Nd, Sm, Eu, Gd, Tb, Dy, Ho, Er, Tm, Yb, Lu, Mn, Bi, and Sb, and preferably Eu²⁺, Ce³⁺, Tb³⁺, Yb²⁺ and Mn²⁺.

The second nitride-based phosphor is represented by a formula of CaAlSiN₃:Eu.

The mixing weight ratio of the first oxynitride-based phosphor to the second nitride-based phosphor may be preferably from about 9:1 to about 8:2, and more preferably about 8.04:1.95. The CIE color coordinates of the emission of the phosphor compositions satisfy the following equation: y = 0.0805x³ - 154.06x² + 97017x - 2E+07. The CIE color coordinates of the emission of the phosphor compositions fall within a region defined by points having coordinates of (0.30, 0.25), (0.30, 0.43), (0.39, 0.25), and (0.39, 0.43).

Table 1 summarizes the CIE color coordinates of example embodiments of phosphor compositions according to the present disclosure.

**Table 1. CIE Color Coordinates of Phosphor Compositions**

| Phosphor Composition | | CIE Coordinates | |
|---|---|---|---|
| First phosphor M(II)ₐSi_{b}O_{c}N_{d}Cₑ:A | Second Phosphor CaAlSiN₃:Eu | X | Y |
| 8.04 | 1.95 | 0.365 | 0.372 |
| 8.74 | 1.26 | 0.363 | 0.374 |
| 8.98 | 1.02 | 0.356 | 0.380 |

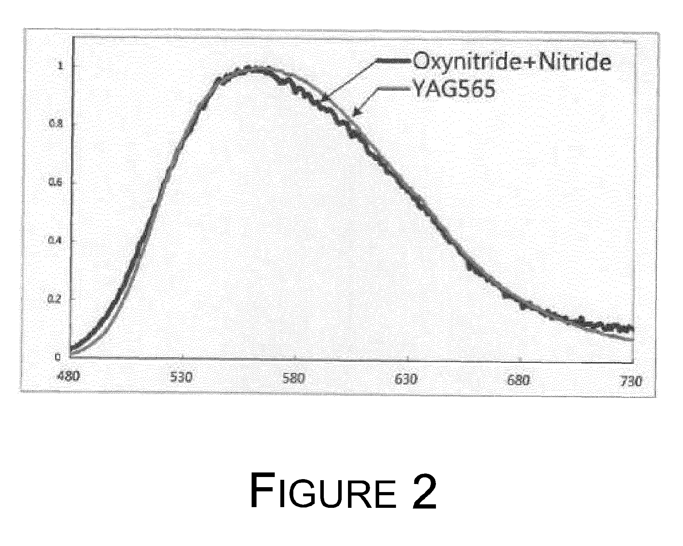

Figure 2 shows a comparison of optical emission between a phosphor composition in accordance with one embodiment of the present disclosure and a yellow YAG phosphor. The weight ratio of the first oxynitride-based phosphor to the second nitride-based phosphor in the phosphor composition 111 is about 8.04:1.05. As shown in Figure 2, the phosphor composition 111 has a broad emission ranging from 480 nm to 730 nm with a peak wavelength at about 550 nm. The emission spectrum of the phosphor composition is very similar to that of the yellow YAG phosphor.

The above-described phosphor composition 111 may include a diffuser (5-15% (w/w) with particle size D₅₀ of 1 -10 µm) to increase the brightness of the white LED device 100. The diffuser may comprise, for example, ZnO₂, SiO₂, TiO₂, Al₂O₃, or a combination thereof.

It is worth mentioning that, to enhance the excitation efficiency of the phosphor composition 111 in the white LED device 100, the concentration of the phosphor composition 111 may be gradually increased from the surface of the encapsulant layer 109 towards the surface of the blue LED 101. The blue LED 101 may be covered by the phosphor composition 111 of a common form, and in such case the phosphor composition 111 of a common form may be formed by spraying, molding, printing, etc. Alternatively, the blue LED 101 may be indirectly covered by the phosphor composition 111. The phosphor composition 111 may be disposed a distance away from the blue LED 101 and still be excited by the blue LED 101. For example, the phosphor composition 111 may be mixed with resin to form a phosphor plate or light guide plate, or may be spread over a resin plate or disposed above a light guide plate. This way, the light uniformity, as well as the thermal tolerance of the phosphor composition 111 with respect to the high heat generated by the blue LED 101, may be enhanced.

In summary, the phosphor compositions used in the white LED device of the present disclosure have the emission in the yellow region similar to that of a yellow YAG phosphor, and do not have the thermal instability problem of the silicate-based phosphors. Therefore, the phosphor compositions of the present disclosure can effectively replace the conventional YAG phosphor and silicate-based phosphors to provide white LEDs with high reliability.

A number of embodiments of the present disclosure are described herein. However, as those skilled in the art would appreciate, the scope of the present disclosure is not and cannot be limited to the disclosed embodiments. More specifically, one ordinarily skilled in the art may make various deviations and improvements based on the disclosed embodiments, and such deviations and improvements are still within the scope of the present disclosure. Accordingly, the scope of protection of a patent issued from the present disclosure is determined by the claims provided below.

## Claims

1. A phosphor composition, comprising:
a first oxynitride-based phosphor that emits green light ; and
a second nitride-based phosphor that emits red light ,
wherein the phosphor composition has an emission with CIE color coordinates satisfying an equation expressed as:
y = 0.0805x3 - 154.06x2 + 97017x - 2E+07.

2. The phosphor composition of Claim 1, wherein the first oxynitride-based phosphor is represented by a general formula of M(II)ₐSi_{b}O_{c}N_{d}Cₑ:A, M(II) comprising at least one divalent cation selected from the group consisting of Be, Mg, Ca, Sr, Ba, Cu, Co, Ni, Pd, Zn, and Cd, A comprising a luminescence activator selected from the group consisting of Ce, Pr, Nd, Sm, Eu, Gd, Tb, Dy, Ho, Er, Tm, Yb, Lu, Mn, Bi, and Sb, and 6<a<8, 8<b<14, 13<c<17, 5<d<9, and 0<e<2.

3. The phosphor composition of Claim 1, wherein the second nitride-based phosphor is represented by a formula of CaAlSiN₃:Eu.

4. The phosphor composition of Claim 1, wherein a weight ratio of the first oxynitride-based phosphor to the second nitride-based phosphor is from about 8:2 to about 9:1.

5. The phosphor composition of Claim 4, wherein the weight ratio of the first oxynitride-based phosphor to the second nitride-based phosphor is about 8.04:1.95.

6. The phosphor composition of Claim 1, wherein the CIE color coordinates of the emission of the phosphor composition fall within a region defined by points having coordinates of (0.30, 0.25), (0.30, 0.43), (0.39, 0.25), and (0.39, 0.43).

7. The phosphor composition of Claim 6, wherein the CIE color coordinates of the emission of the phosphor composition are at (0.365, 0.372).

8. A phosphor composition, comprising:
a first oxynitride-based phosphor represented by a general formula of M(II)ₐSi_{b}O_{c}N_{d}Cₑ:A; and
a second nitride-based phosphor represented by a formula of CaAlSiN₃:Eu,
wherein:
M(II) comprises at least one divalent cation selected from the group consisting of Be, Mg, Ca, Sr, Ba, Cu, Co, Ni, Pd, Zn, and Cd,
A comprises a luminescence activator selected from the group consisting of Ce, Pr, Nd, Sm, Eu, Gd, Tb, Dy, Ho, Er, Tm, Yb, Lu, Mn, Bi, and Sb,
6<a<8, 8<b<14, 13<c<17, 5<d<9, and 0<e<2, and
a weight ratio of the first oxynitride-based phosphor to the second nitride-based phosphor is from about 8:2 to about 9:1.

9. The phosphor composition of Claim 8, wherein the weight ratio of the first oxynitride-based phosphor to the second nitride-based phosphor is about 8.04:1.95.

10. The phosphor composition of Claim 8, wherein the phosphor composition has an emission with CIE color coordinates satisfying an equation expressed as:
y = 0.0805x³ - 154.06x² + 97017x - 2E+07.

11. The phosphor composition of Claim 10, wherein the CIE color coordinates of the emission of the phosphor composition fall within a region defined by points having coordinates of (0.30, 0.25), (0.30, 0.43), (0.39, 0.25), and (0.39, 0.43).

12. A phosphor composition, comprising:
a first oxynitride-based phosphor represented by a general formula of M(II)ₐSi_{b}O_{c}N_{d}Cₑ:A; and
a second nitride-based phosphor represented by a formula of CaAlSiN₃:Eu,
wherein:
M(II) comprises at least one divalent cation selected from the group consisting of Be, Mg, Ca, Sr, Ba, Cu, Co, Ni, Pd, Zn, and Cd,
A comprises a luminescence activator selected from the group consisting of Ce, Pr, Nd, Sm, Eu, Gd, Tb, Dy, Ho, Er, Tm, Yb, Lu, Mn, Bi, and Sb,
6<a<8, 8<b<14, 13<c<17, 5<d<9, and 0<e<2, and
the phosphor composition has an emission with CIE color coordinates in a range of 0.356 ≤ x ≤ 0.365 and 0.372 ≤ y ≤ 0.380.

13. The phosphor composition of Claim 12, wherein a weight ratio of the first oxynitride-based phosphor to the second nitride-based phosphor is from about 8:2 to about 9:1.

14. The phosphor composition of Claim 13, wherein the weight ratio of the first oxynitride-based phosphor to the second nitride-based phosphor is about 8.04:1.95.

15. The phosphor composition of Claim 12, wherein the phosphor composition has an emission with CIE color coordinates satisfying an equation expressed as:
y = 0.0805x³ - 154.06x² + 97017x - 2E+07.

16. A light-emitting diode (LED) device, comprising:
a blue LED having a peak emission wavelength in a range of 450 nm - 460 nm; and
a phosphor composition disposed on or over the blue LED, the phosphor composition comprising:
a first oxynitride-based phosphor having a peak emission wavelength in a range of 550 nm - 560 nm; and
a second nitride-based phosphor having a peak emission wavelength in a range of 615 nm - 700 nm,
wherein the phosphor composition has an emission with CIE color coordinates satisfying an equation expressed as:
y = 0.0805x³ - 154.06x² + 97017x - 2E+07.

17. The LED device of Claim 16, wherein the first oxynitride-based phosphor is represented by a general formula of M(II)ₐSi_{b}O_{c}N_{d}Cₑ:A, M(II) comprising at least one divalent cation selected from the group consisting of Be, Mg, Ca, Sr, Ba, Cu, Co, Ni, Pd, Zn, and Cd, A comprising a luminescence activator selected from the group consisting of Ce, Pr, Nd, Sm, Eu, Gd, Tb, Dy, Ho, Er, Tm, Yb, Lu, Mn, Bi, and Sb, and 6<a<8, 8<b<14, 13<c<17, 5<d<9, and 0<e<2..

18. The LED device of Claim 16, wherein the second nitride-based phosphor is represented by a formula of CaAlSiN₃:Eu.

19. The LED device of Claim 16, wherein a weight ratio of the first oxynitride-based phosphor to the second nitride-based phosphor is from about 8:2 to about 9:1.

20. The LED device of Claim 19, wherein the weight ratio of the first oxynitride-based phosphor to the second nitride-based phosphor is about 8.04:1.95.

21. The LED device of Claim 16, wherein the CIE color coordinates of the emission of the phosphor composition fall within a region defined by points having coordinates of(0.30, 0.25), (0.30, 0.43), (0.39, 0.25), and (0.39, 0.43).

22. The LED device of Claim 21, wherein the CIE color coordinates of the emission of the phosphor composition are in a range of 0.356 ≤ x ≤ 0.365 and 0.372 ≤ y ≤ 0.380.

23. The LED device of Claim 16, wherein CIE Color coordinates of emission of the LED device are in a range of 0.28 ≤ x ≤ 0.39 and 0.25 ≤ y ≤ 0.35.

24. The LED device of Claim 16, further comprising a diffuser.

25. The LED device of Claim 24, wherein the diffuser comprises ZnO₂, SiO₂, TiO₂, Al₂O₃, or a combination thereof.
